# EUROPEAN PATENT APPLICATION

(11) **EP 4 800 413 A1**
(43) Date of publication of application: **02.09.2026**
(21) Application number: 25160781.8
(22) Date of filing: 28.02.2025
(51) Int. Cl.: G01R 33/00, G01R 33/07

(54) **HALL SENSOR SYSTEM**

(71) Applicant: LEM International SA, 1217 Meyrin (CH)
(72) Inventor: CIOMAGA, Dan, 85051 Ingolstadt (DE)
(74) Representative: reuteler & cie SA

(57) **Abstract**

Hall sensor system (1) comprising at least one Hall cell (2a, 2b) and a signal processing circuit (3) comprising a chopper (5), a first channel (A), a second channel (B), a demodulator (6) and a ripple reduction circuit (7), each of the at least one Hall cells (2a, 2b) comprising first and second pairs of contacts defining first and second directions perpendicular to each other for applying bias voltages *Vbias, Vtop* or bias currents *Ibias* and sensing Hall voltages *V1AC, V1DB, V2AC, V2DB.* The chopper (5) is connected to the first and second pairs of contacts of the at least one Hall cells (2a, 2b) and configured to generate a four-phase spinning-current at each of the at least one Hall cells (2a, 2b). The first pair of contacts (c1D, c1B; c2A, c2C) of each of the at least one Hall cells (2a, 2b) is connected to an input (8A) of the first channel (A) for sensing Hall voltages *V1DB, V2AC* in the first direction during first and third phases of a four-phase spinning-current cycle and the second pair of contacts (c2D, c2B; c1A, c1C) of each of the at least one Hall cells (2a, 2b) is connected to an input (8B) of the second channel (B) for sensing Hall voltages *V1AC, V2DB* in the second direction during second and fourth phases of the four-phase spinning-current cycle. The demodulator (6) is configured to demodulate the signs of the Hall voltages sensed during the first to fourth phase to provide a demodulated Hall signal and to chronologically combine the demodulated Hall signal to provide an output signal. The ripple reduction circuit (7) comprises a first ripple reduction loop (13A) in the first channel (A) and a second ripple reduction loop (13B) in the second channel (B) configured to at least partially compensate a Hall cell offset based on a subtraction of the demodulated Hall signal of the second channel from the demodulated Hall signal of the first channel.

## Description

The present invention relates to a Hall sensor system, in particular a Hall sensor system with a ripple reduction loop. The present invention further relates to a current transducer comprising a Hall sensor system, in particular a current transducer comprising a Hall sensor system with a ripple reduction loop.

Hall sensor systems are known for measuring a primary current in a primary conductor through the magnetic field generated by the primary current.

The primary focus of the invention is the signal chain, also referred to as read-out electronics, that senses the output voltage of a pair of Hall cells and processes it to deliver at the output of the chain a voltage proportional to the primary current that generated the magnetic field sensed by the Hall cells.

In a standard spinning architecture with sample and hold demodulation, as described in US5621319A, the demodulator is the major obstacle in increasing signal chain bandwidth and decreasing response time. These can only be improved by increasing Hall cell spinning frequency. The sample and hold demodulator is good at removing errors but sets a hard upper limit on the signal chain bandwidth.

Other architectures [1],[3] employ standard spinning with chopping techniques for demodulation. Ripple reduction loops are used to remove static/dynamic errors. Bandwidth increase, above half spinning frequency, is done either by multi-path techniques, as described in J. Jiang and K. A. A. Makinwa, "Multipath wide-bandwidth CMOS magnetic sensors," IEEE J. Solid-State Circuits, vol. 52, no. 1, pp. 198-209, Jan. 2017, or by randomized spinning, as described in Riem, R.; Raman, J.; Rombouts, P.; "A 2MS/s Full Bandwidth Hall System with Low Offset Enabled by Randomized Spinning", Sensors 2022, 22, 6069.

In a standard architecture of a current-biased spinning-current operated Hall-effect sensor, the readout switches are directly connected to the contacts of the Hall cell and the sensed Hall voltage is amplified after the readout switches by an amplifier. A non-standard readout circuit for reducing the capacitive load for the Hall probe is described in Crescentini, M.; Marchesi, M.; Romani, A.; Tartagni, M.; Traverso, P.A. "A Broadband, On-Chip Sensor Based on Hall Effect for Current Measurements in Smart Power", Circuits. IEEE Trans. Instrum. Meas. 2018, 67, 1470-1485. The readout circuit disclosed in this document first amplifies the sensed Hall voltages and then inputs the amplified Hall voltages into a switched capacitor circuit for the demodulation of the signal.

The signal chain is designed to achieve high bandwidth and small response time while at the same time maintaining high static and dynamic accuracy.

In view of the foregoing, it is an object of the invention to provide a Hall sensor system, which has a high bandwidth and a small response time while at the same time maintaining high static and dynamic accuracy.

It is advantageous to provide a Hall sensor system, which has a signal chain bandwidth higher than half the spinning frequency.

Objects of the invention have been achieved by providing a Hall sensor system and a current transducer according to the independent claims.

Dependent claims set out various advantageous features of embodiments of the invention.

Disclosed herein is a Hall sensor system comprising at least one Hall cell and a signal processing circuit comprising a chopper, a first channel, a second channel, a demodulator and a ripple reduction circuit, each of the at least one Hall cells comprising first and second pairs of contacts defining first and second directions perpendicular to each other for applying bias voltages *Vbias, Vtop* or bias currents *Ibias* and sensing Hall voltages *V1AC, V1DB, V2AC, V2DB.* The chopper is connected to the first and second pairs of contacts of the at least one Hall cells and configured to generate a four-phase spinning-current at each of the at least one Hall cells. The first pair of contacts of each of the at least one Hall cells is connected to an input of the first channel for sensing Hall voltages *V1DB, V2AC* in the first direction during first and third phases of a four-phase spinning-current cycle and the second pair of contacts of each of the at least one Hall cells is connected to an input of the second channel for sensing Hall voltages *V1AC, V2DB* in the second direction during second and fourth phases of the four-phase spinning-current cycle. The demodulator is configured to demodulate the signs of the Hall voltages sensed during the first to fourth phase to provide a demodulated Hall signal and to chronologically combine the demodulated Hall signal to provide an output signal, the ripple reduction circuit comprising a first ripple reduction loop in the first channel and a second ripple reduction loop in the second channel configured to at least partially compensate a Hall cell offset based on a subtraction of the demodulated Hall signal of the second channel from the demodulated Hall signal of the first channel.

In an advantageous embodiment, the at least one Hall cell are a first Hall cell and a second Hall cell.

In an advantageous embodiment, the at least one Hall cell are a first plurality of Hall cells connected in parallel and a second plurality of Hall cell connected in parallel.

In an advantageous embodiment, each of the first and second channels comprises a differential amplifier directly connected to one of the first and second pairs of contacts of each of the at least one Hall cells.

In an advantageous embodiment, the differential amplifiers of the first and second channels are low noise amplifiers.

In an advantageous embodiment, the first and second ripple reduction loops are configured to at least partially compensate an average Hall cell offset and a dynamic offset based on the subtraction of the demodulated Hall signal of the second channel from the demodulated Hall signal of the first channel.

In an advantageous embodiment, the first and second ripple reduction loops are configured to at least partially compensate an average Hall cell offset and a dynamic offset based on the subtraction of the demodulated Hall signal of the second channel from the demodulated Hall signal of the first channel and a subsequent integration of the subtraction.

In an advantageous embodiment, the ripple reduction circuit further comprises a third ripple reduction loop in the first channel for at least partially compensating a differential Hall cell offset between the first and third phases, and wherein the ripple reduction circuit further comprises a fourth ripple reduction loop in the second channel for at least partially compensating a differential Hall cell offset between second and fourth phases.

In an advantageous embodiment, the third ripple reduction loop comprises an integrator configured to store a value of half the differential Hall cell offset between the first and third phases and the fourth ripple reduction loop comprises an integrator configured to store the value of half the differential Hall cell offset between second and fourth phases.

In an advantageous embodiment, the ripple reduction circuit further comprises a fifth ripple reduction loop configured to adjust a frequency of the four-phase spinning-current as a function of outputs of the integrators of the third and fourth ripple reduction loops.

Also disclosed herein is a current transducer for measuring a current in a primary conductor, the current transducer comprising the Hall sensor system according to any preceding embodiment.

Further advantageous features of the invention will be apparent from the following detailed description of embodiments of the invention and the accompanying illustrations.

### Brief description of the figures

Figure 1 is a schematic view of a Hall sensor system according to an embodiment of the invention;
Figure 2 is an illustration of the clock signals used in the signal processing circuit, in particular for generating a four-phase spinning-current;

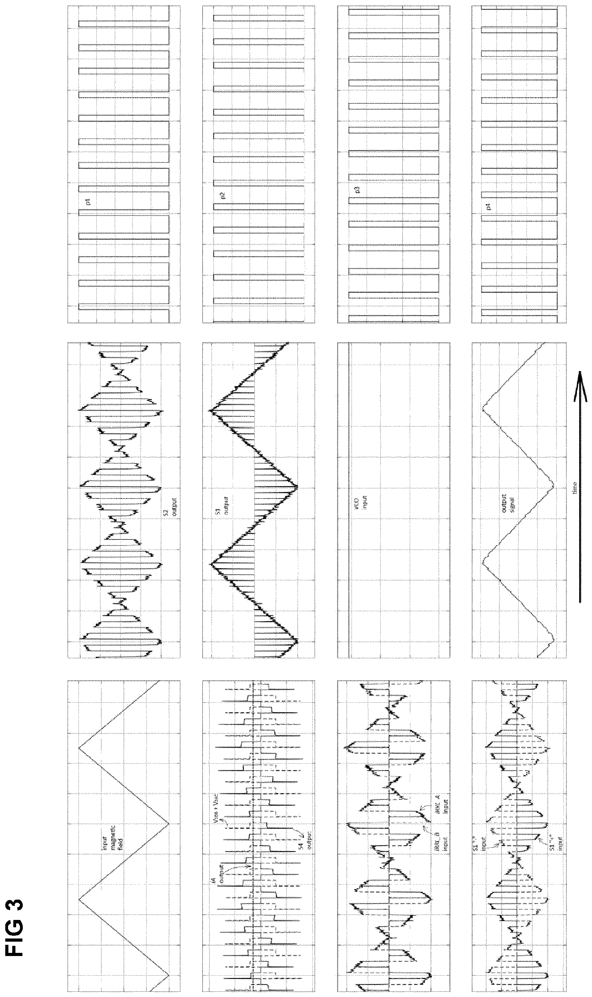

Figure 3 shows different signals as a function of time in a Hall sensor system according to an embodiment of the invention in a typical operation of the system.

Referring to the figures, a Hall sensor system 1 according to embodiments of the invention comprises at least one Hall cell 2a, 2b and a signal processing circuit 3 comprising a clock generator 4, a chopper 5, a first channel A, a second channel B, a demodulator 6 and a ripple reduction circuit 7.

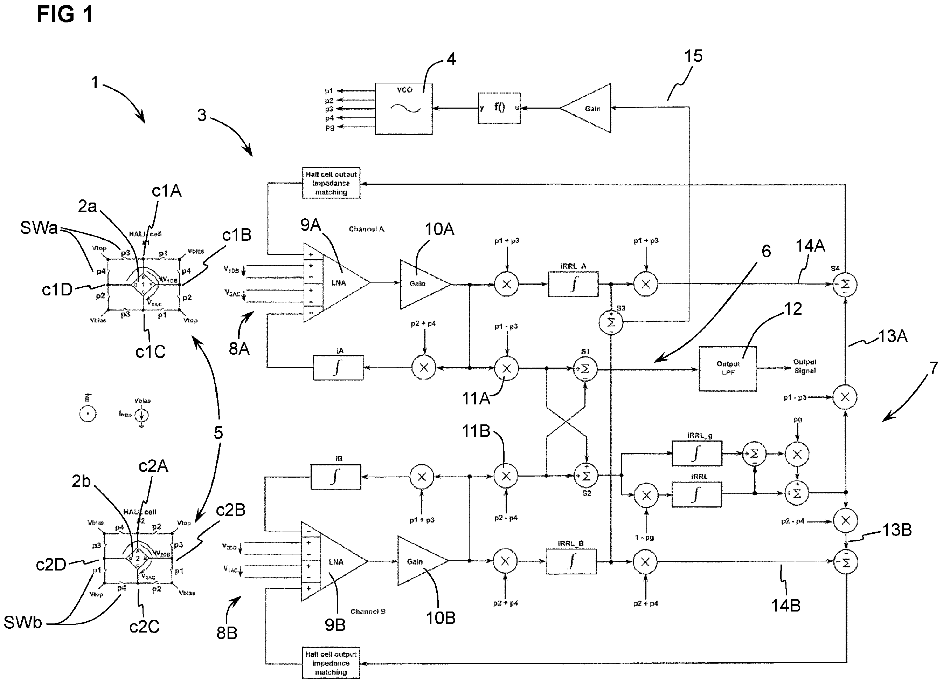

In the embodiment illustrated in figure 1, the at least one Hall cell are a first Hall cell 2a and a second Hall cell 2b.

In another embodiment of the invention, the at least one Hall cell are a first plurality of Hall cells connected in parallel and a second plurality of Hall cell connected in parallel.

In a variant (not shown in the figures), the at least one Hall cell is a single Hall cell or a plurality of Hall cells connected in parallel. The modification to the signal processing circuit 3 of figure 1 is straightforward (each of the first and second channels A, B only senses one Hall voltage instead of two Hall voltages).

Each of the first and second Hall cells 2a, 2b comprises a first pair of contacts (c1D, c1B; c2A, c2C) defining a first direction and a second pair of contacts (c2D, c2B; c1A, c1C) defining a second direction perpendicular to the first direction for applying a bias voltage *Vbias, Vtop* (or bias current *Ibias*) on one of the first and second pairs of contacts and sensing a Hall voltage *V1AC, V1DB, V2AC, V2DB* at the other one of the first and second pairs of contacts. Thus, the direction of the applied bias voltage *Vbias, Vtop* (or bias current *Ibias*) is perpendicular to the direction of the sensed Hall voltage in each phase and Hall voltages are sensed in perpendicular directions in subsequent phases of the four-phase spinning-current cycle.

The chopper 5 in combination with the clock generator 4 implements four-phase spinning-current, which is a technique well known *per se.* The clock generator 4 is configured to generate first, second, third and fourth clock signals p1-p4 corresponding to the four phases of the spinning cycle, i.e., the signal processing circuit 3 is said to be in the phase corresponding to the clock that is high (1), while the other three clocks are low (0). The chopper 5 comprises a switch SWa, SWb between each contact c1A-c1D, c2A-c2D of the Hall cells 2a, 2b and each bias voltage *Vbias* and *Vtop* (or connection ends of a current source for generating a bias current *Ibias*). Vtop is an arbitrary voltage different from *Vbias.* For example, *Vtop* may be set to ground.

Each of the switches SWa, SWb of the chopper 5 is controlled by one of the first to fourth clock signals p1-p4. The switches SWa, SWb of the chopper 5 are closed when the corresponding controlling clock signal is high (1) and open when the corresponding controlling clock signal is low (0). Thus, the chopper 5 closes one pair of switches at a time and keeps the other three pairs of switches open to apply a bias voltage or bias current at one pair of contacts of the Hall cell. The Hall voltage is sensed at the other pair of the contacts of the Hall cell.

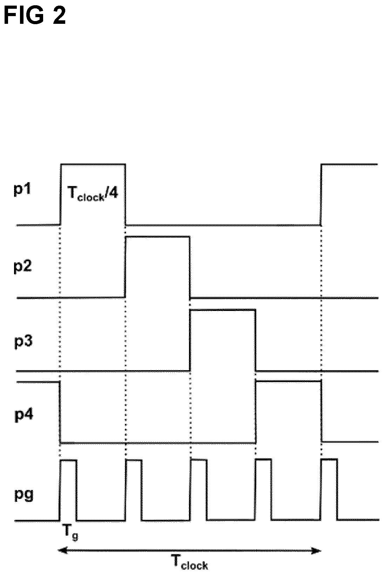

The applied bias voltage (and thus the bias current) makes a full rotation during a full spinning cycle. As depicted in Fig. 2, each of the first to fourth clock signals p1-p4 has an "ON-state" (or "high" or value 1) during approximately a fourth of the duration of a full spinning cycle duration Tclock and an "OFF-state" (or "low" or value 0) during approximately three quarters of the duration of a full spinning cycle duration Tclock. In practice, the shape of the waveforms of the first to fourth clock signals p1-p4 may deviate from ideal square waveforms.

In the literature, the spinning frequency is defined as the frequency of switching of the bias current, which is equal to 4/Tclock.

The first pair of contacts c1D, c1B; c2A, c2C of each of the at least one Hall cells 2a, 2b is connected to an input 8A of the first channel A for sensing Hall voltages V1DB, V2AC in the first direction during first and third phases of a four-phase spinning-current cycle and the second pair of contacts c2D, c2B; c1A, c1C of each of the at least one Hall cells 2a, 2b is connected to an input 8B of the second channel B for sensing Hall voltages V1AC, V2DB in the second direction during second and fourth phases of the four-phase spinning-current cycle. The first to fourth phases are chronologically ordered and the first and second channels A, B are synchronized because they are controlled by the same first to fourth clock signals. Thus, the first and second channels A, B work in a time-interleaved manner.

In the illustrated embodiment, the two orthogonal directions of the Hall voltages of each Hall cell are sensed directly by two differential amplifiers 9A, 9B that are placed at the input 8A, 8B of each channel A, B. In other words, the differential amplifiers are directly connected to the contacts of the Hall cells without any readout switches in between. Each differential amplifier senses one Hall voltage from each of the two Hall cells. The differential amplifiers 9A, 9B output the sums of the sensed Hall voltages (corrected by other inputs from the ripple reduction circuit, which will be discussed later in the description).

In preferred embodiments, the differential amplifiers are low noise amplifiers (LNAs).

The outputs of the differential amplifiers 9A, 9B are preferably connected to the inputs of single-ended amplifiers 10A, 10B for further amplifying the sensed Hall signals.

The demodulator 6 is configured to chronologically combine the Hall voltages sensed by the first and second channels A, B and correct polarities (or signs) of the Hall voltages sensed during the first to fourth phase. The signal processing circuit 3 does not comprise a sample- and-hold circuit. The sensed Hall voltage signals are directly propagated from the inputs of the output of the signal processing circuit 3 without temporarily storing the signals using capacitors.

In the illustrated embodiment, the demodulator 6 is implemented as follows. The Hall voltage sensed during first and third phases is extracted from the first channel A using a first signal extractor 11A comprising a multiplier connected to the output of the first single-ended amplifier 10A. The signal is multiplied with the first clock signal minus the third clock signal p1-p3. The signal is extracted only when the Hall signal is actually sensed by the first channel A because the first and third clock signals p1, p3 are zero during the rest of the spinning cycle. The inversion of the third clock corrects the different sign of the Hall signal in the third phase in comparison with the sign in the first phase.

Likewise, the Hall voltage sensed during second and fourth phases is extracted from the second channel B using a second signal extractor 11B comprising a multiplier connected to the output of the second single-ended amplifier 10B. The signal is multiplied with the second clock signal minus the fourth clock signal p2-p4. The signal is extracted only when the Hall signal is actually sensed by the second channel B because the second and fourth clock signals p2, p4 are zero during the rest of the spinning cycle. The inversion of the fourth clock corrects the different sign of the Hall signal in the fourth phase in comparison with the sign in the second phase.

The demodulator further comprises a signal combiner S1 for combining the output signals of the first and second extractors 11A, 11B. The signal combiner S1 is a summator, which subtracts the output signal of the second extractor 11B from the output signal of the first extractor 11A. The minus sign is required to demodulate the signs, i.e., correct the different signs of the Hall signal in the different phases.

The signal processing circuit 3 may further comprise an output filter 12, which is preferably a low pass filter. The output filter 12 is connected to the output of the demodulator 6. In the illustrated embodiment, the output signal of the output filter 12 is the output signal provided by the Hall sensor system 1.

During the first and third phases, the LNA at the input of the first channel A senses the useful, magnetic field induced voltages *V*₁*_{DB} = V*₂*_{AC} = S_{B} · B and V*_{1*DB*} = *V*₂*_{AC} = -S_{B} · B,* plus measurement offsets. During the second and fourth phases, the LNA at the input of the first channel A senses the voltages *V*₁*_{DB} =* -*V*₂*_{AC} = -Vₜₒₚ + V_{bias}* and *V*₁*_{DB} = -V*₂*_{AC} = +Vₜₒₚ - V_{bias}* respectively. The Hall cell sensed signal is processed further only during the first and third phases. During the second and fourth phases, the input sum is *V*₁*_{DB} + V*_{2*AC*} = 0 and the LNA and subsequent gain stage are autozeroed with the help of integrator *iA*.

During the second and fourth phases, the LNA at the input of second channel B senses the useful, magnetic field induced voltages *V*₂*_{DB} = V*₁*_{AC} = -S_{B} · B and V*₂*_{DB} = V*₁*_{AC} = S_{B} · B,* plus measurement offsets. During the first and third phases, the LNA at the input of second channel B senses the voltages *V*₂*_{DB} = -V*₁*_{AC} =* +*Vₜₒₚ* - *V_{bias}* and *V*_{2*DB*} = *-V*_{1*AC*} = *-Vₜₒₚ + V_{bias}* respectively. The Hall cell sensed signal is processed further only during the second and fourth phases. During the first and third phases, the input sum is *V*₂*_{DB} + V*_{1*AC*} = 0 and the LNA and subsequent gain stage are autozeroed with the help of integrator *iB.*

The ripple reduction circuit 7 comprises first and second ripple reduction loops 13A, 13B for at least partially compensating an average Hall cell offset across the four spinning phases. The first and second ripple reduction loops 13A, 13B share a summator S2, which sums the outputs of first and second signal extractors 11A and 11B. Thus, the output of the summator S2 is the demodulated Hall signal of the first channel A minus the demodulated Hall signal of the second channel B. In other words, the summator S2 subtracts the demodulated Hall signals of the even phases from the demodulated Hall signals of the odd phases.

The output of the summator S2 feeds into a first integrator iRRL that is part of two loops, one around each of the first and second channel A, B. The average Hall cell offset (sensed Hall cell voltage with no input magnetic field) is stored by the first integrator iRRL and subtracted (with the respective sign for offset compensation) at the LNAs 9A, 9B during the relevant phases p1 and p3 or p2 and p4, respectively.

In preferred embodiments, the output of the summator S2 also feeds into a second integrator iRRL_g. In steady state, this integrator stores the average Hall cell offset (across the four phases) plus the dynamic error (offset), such as the error spikes at the transition between phases due to a non-zero time required to evacuate the charge on the Hall cell plates associated with the bias voltage from the previous phase.

The difference between values stored in the first and second integrators *iRRL* and *iRRL_g* modulates a square wave carrier (pg in Fig. 2) whose pulse width is chosen to match that of the dynamic error spikes.

In preferred embodiments, the ripple reduction circuit 7 further comprises a third ripple reduction loop 14A in the first channel A for at least partially compensating a differential Hall cell offset between phases 1 and 3. The ripple reduction circuit 7 further comprises a fourth ripple reduction loop 14B in the second channel B for at least partially compensating a differential Hall cell offset between phases 2 and 4.

The third ripple reduction loop 14A comprises an integrator iRRL_A configured to store the value of half the differential Hall cell offset between phases 1 and 3.

The fourth ripple reduction loop 14B comprises an integrator iRRL_B configured to store the value of half the differential Hall cell offset between phases 2 and 4.

All the offset compensations in the first to fourth ripple reduction loops are gated with the corresponding clock pulses p1-p4 and pg generated by the clock generator and with the correct sign for compensating the respective offset and phase.

In preferred embodiments, the ripple reduction circuit 7 further comprises a fifth ripple reduction loop 15 for controlling the frequency of the four spinning clocks p1-p4. This is done by combining the output of integrators iRRL_A and iRRL_B of the third and fourth ripple reduction loops 14A, 14B at a summation point S3. The output of S3 is amplified and feed into a block, denoted f() in Fig.1, whose purpose is to detect a change of the values stored in the above-mentioned integrators. Potential functions *f*(*u*) implemented by the block are *±min*(*u*)*,* ±*max*(*u*), ±*max*(*u*) ± *min*(*u*). The output *y = f*(*u*) of the block controls a VCO (voltage-controlled oscillator) that generates the four spinning clocks.

This mechanism is needed to avoid having the frequency of the spinning clocks coincide with a harmonic of the input signal (input magnetic field) in which case a DC component would appear, due to the modulating nature of spinning, at the input of the *iRRL_A* and/or *iRRL_B* integrators which would be integrated and feed back at the input of the LNAs resulting in significant signal distortion throughout the signal chain.

This mechanism allows the bandwidth of the signal chain to be extended to up to 2 times the spinning clocks frequency.

### List of references

Current transducer
Hall sensor system 1
Hall cells 2a, 2b
   contacts c1A-c1D, c2A-c2D
   Hall voltages V1AC, V1DB, V2AC, V2DB
   bias voltages Vbias, Vtop
signal processing circuit 3
   clock generator 4
      voltage controlled oscillators VCO
      clock signals *p1-p4, pg*
      clock period *Tclock*
      gate period Tg
   chopper 5
      switches SWa, SWb
   channels A, B
      inputs 8A, 8B
      differential (low noise) amplifiers 9A, 9B
      single-ended amplifiers 10A, 10B
   demodulator 6
      signal extractor, multiplier 11A, 11B
      signal combiner, summator S1
   ripple reduction circuit 7
      first and second ripple reduction loops 13A, 13B
         summator S2
         integrators iRRL, iRRL_g
      third and fourth ripple reduction loops 14A, 14B integrators iRRL_A, iRRL_B
      fifth ripple reduction loop 15
   output filter 12
      low pass filter

## Claims

1. Hall sensor system (1) comprising at least one Hall cell (2a, 2b) and a signal processing circuit (3) comprising a chopper (5), a first channel (A), a second channel (B), a demodulator (6) and a ripple reduction circuit (7), each of the at least one Hall cells (2a, 2b) comprising first and second pairs of contacts defining first and second directions perpendicular to each other for applying bias voltages *Vbias, Vtop* or bias currents *Ibias* and sensing Hall voltages *V1AC, V1DB, V2AC, V2DB,* wherein the chopper (5) is connected to the first and second pairs of contacts of the at least one Hall cells (2a, 2b) and configured to generate a four-phase spinning-current at each of the at least one Hall cells (2a, 2b), wherein the first pair of contacts (c1D, c1B; c2A, c2C) of each of the at least one Hall cells (2a, 2b) is connected to an input (8A) of the first channel (A) for sensing Hall voltages *V1DB, V2AC* in the first direction during first and third phases of a four-phase spinning-current cycle and the second pair of contacts (c2D, c2B; c1A, c1C) of each of the at least one Hall cells (2a, 2b) is connected to an input (8B) of the second channel (B) for sensing Hall voltages *V1AC, V2DB* in the second direction during second and fourth phases of the four-phase spinning-current cycle, wherein the demodulator (6) is configured to demodulate the signs of the Hall voltages sensed during the first to fourth phase to provide a demodulated Hall signal and to chronologically combine the demodulated Hall signal to provide an output signal, the ripple reduction circuit (7) comprising a first ripple reduction loop (13A) in the first channel (A) and a second ripple reduction loop (13B) in the second channel (B) configured to at least partially compensate a Hall cell offset based on a subtraction of the demodulated Hall signal of the second channel from the demodulated Hall signal of the first channel.

2. Hall sensor system according to the claim 1, wherein the at least one Hall cell are a first Hall cell (2a) and a second Hall cell (2b).

3. Hall sensor system according to the claim 1, wherein the at least one Hall cell are a first plurality of Hall cells connected in parallel and a second plurality of Hall cell connected in parallel.

4. Hall sensor system according to any preceding claim, wherein each of the first and second channels (A, B) comprises a differential amplifier (9A, 9B) directly connected to one of the first and second pairs of contacts of each of the at least one Hall cells.

5. Hall sensor system according to the directly preceding claim, wherein the differential amplifiers (9A, 9B) of the first and second channels (A, B) are low noise amplifiers.

6. Hall sensor system according to any preceding claim, wherein the first and second ripple reduction loops (13A, 13B) are configured to at least partially compensate an average Hall cell offset and a dynamic offset based on the subtraction of the demodulated Hall signal of the second channel (B) from the demodulated Hall signal of the first channel (A).

7. Hall sensor system according to the directly preceding claim, wherein the first and second ripple reduction loops (13A, 13B) are configured to at least partially compensate an average Hall cell offset and a dynamic offset based on the subtraction of the demodulated Hall signal of the second channel (B) from the demodulated Hall signal of the first channel (A) and a subsequent integration of the subtraction.

8. Hall sensor system according to any preceding claim, wherein the ripple reduction circuit (7) further comprises a third ripple reduction loop (14A) in the first channel (A) for at least partially compensating a differential Hall cell offset between the first and third phases, and wherein the ripple reduction circuit (7) further comprises a fourth ripple reduction loop (14B) in the second channel (B) for at least partially compensating a differential Hall cell offset between second and fourth phases.

9. Hall sensor system according to the directly preceding claim, wherein the third ripple reduction loop (14A) comprises an integrator (iRRL_A) configured to store a value of half the differential Hall cell offset between the first and third phases and the fourth ripple reduction loop (14B) comprises an integrator (iRRL_B) configured to store the value of half the differential Hall cell offset between second and fourth phases.

10. Hall sensor system according to the directly preceding claim, wherein the ripple reduction circuit (7) further comprises a fifth ripple reduction loop (15) configured to adjust a frequency of the four-phase spinning-current as a function of outputs of the integrators (iRRL_A, iRRL_B) of the third and fourth ripple reduction loops (14A, 14B).

11. Current transducer for measuring a current in a primary conductor, the current transducer comprising the Hall sensor system (1) according to any preceding claim.
